# EUROPEAN PATENT APPLICATION

(11) **EP 1 494 514 A2**
(43) Date of publication of application: **05.01.2005**
(21) Application number: 04015390.0
(22) Date of filing: 30.06.2004
(51) Int. Cl.: H05K 1/16

(54) **Wiring board provided with a resistor and process for manufacturing the same**

(30) Priority: 03.07.2003 JP 2003191363
(71) Applicant: Shinko Electric Industries Co., Ltd., Nagano-shi, Nagano 381-2287 (JP)
(72) Inventor: Tanaka, Koichi, Nagano-shi Nagano 381-2287 (JP)
(74) Representative: von Hellfeld, Axel, Dr. Dipl.-Phys.

(57) **Abstract**

A wiring board (10) provided with a resistor comprises: an insulating substrate (11) having a surface; wiring patterns (14) formed on the surface, the wiring patterns (14) including first and second electrodes (14b,14c) spaced from each other by a certain distance; a first resistor (horizontal type resistor) (30) formed on the surface, the first resistor (30) having respective ends connected with the first and second electrodes (14b,14c), respectively; the wiring patterns (14) further including a third electrode (14a), occupying a first plane area on the surface; a second resistor (vertical type resistor) (16) formed on the third electrode (14a); a fourth electrode (18) formed on the second resistor (16); and the second resistor (16) and the fourth electrode (18) being located in a second plane area within the first plane area.

## Description

### BACKGROUND OF THE INVENTION

### 1. Field of the Invention

The present invention relates to a wiring board provided with a resistor in which the resistor formed thereon can be adjusted and a process for manufacturing the same. More specifically, it relates to a wiring board having a resistor, formed of one kind of resistor paste, the electric resistance of which is selectable from a wide range, and a process for manufacturing the same.

### 2. Description of the Related Art

Among wiring boards carrying semiconductor elements thereon, there is a product manufactured while incorporating a resistor in a substrate by printing a resistor paste, such as a carbon paste, on the substrate itself. When the resistor is formed by a screen printing method, the resistor paste is coated, by printing, in accordance with a predetermined pattern and is heated to a temperature at which the coated resistor paste is cured to become a resistor.

Japanese Unexamined Patent Publication No. 2001-085207 discloses a trimming method, using a laser beam, for adjusting an electric resistance value of a resistor printed on a substrate. According to this method, it is possible, in a short time, to precisely trim the resistor formed by printing.

The electric resistor value of the resistor is adjustable by changing the kind of the resistor paste forming the resistor or the shape of the resistor. For example, to reduce the electric resistance value of the resistor, a cross-sectional area of the resistor is increased relative to a volume thereof. However, there is an allowable limit to a thickness and/or a width determining the cross-sectional area of the resistor, in accordance with a thickness and a width of an electrode. Also, even if it is wished to reduce the electric resistance value of the resistor by shortening a distance between the electrodes, it is difficult to adjust the electric resistance of the resistor in a wide range because micro-printing of the resistor paste is not easy.

Accordingly, when the electric resistances of the resistors used for the wiring board are distributed in a wide range, there is a problem in that a number of kinds of pastes having different resistance values must be prepared, and thus the formation of the resistors becomes troublesome.

Further, when a resinous substrate is used and the electric resistance value of the resistor is adjusted by the laser trimming, the resinous substrate may be damaged by the laser beam, whereby there is another problem in that the resultant wiring board is defective and the yield is low.

### SUMMARY OF THE INVENTION

The present invention has been made to solve the above problems in the prior art, and an object thereof is to provide a wiring board capable of forming resistors having a wide range of electric resistance and in, for example, a range from several hundreds of ohms to several megaohms and, even in a resinous substrate, capable of adjusting the electric resistance of the resistor by the laser trimming or others without damaging the substrate itself, as well as a process for manufacturing such a wiring board.

Thus, according to the present invention, there is provided a wiring board provided with a resistor, comprising: an insulating substrate having a surface; a wiring pattern formed on the surface, the wiring pattern including at least one, first electrode, occupying a first plane area on the surface; a resistor formed on the first electrode; a second electrode formed on the resistor; and the resistor and the second electrode being located in a second plane area within the first plane area.

The second electrode occupies a plane area smaller than that of the resistor.

According to another aspect of the present invention, there is provided a wiring board provided with a resistor, comprising: an insulating substrate having a surface; wiring patterns formed on the surface, the wiring patterns including first and second electrodes spaced from each other by a certain distance; a first resistor formed on the surface, the first resistor having respective ends connected with the first and second electrodes, respectively; the wiring patterns further including a third electrode, occupying a first plane area on the surface; a second resistor formed on the third electrode; a fourth electrode formed on the second resistor; and the second resistor and the fourth electrode being located in a second plane area within the first plane area.

The fourth electrode occupies a plane area smaller than that of the second resistor.

The third electrode is a common electrode with one of the first and second electrodes.

According to still another aspect of the present invention, there is provided a process for manufacturing a wiring board provided with a resistor, comprising the following steps of: forming a wiring pattern on a surface of a insulating substrate in such a manner that the wiring pattern includes at least one, first electrode, occupying a first plane area on the surface; printing a resistor paste on a certain area within a top plane area of the first electrode; heating and curing the printed resistor paste to form a resistor; and forming a second electrode on an area within a top plane area of the resistor.

According to still another aspect of the present invention, there is provided a process for manufacturing a wiring board provided with resistors, comprising the following steps of: forming wiring patterns on a surface of a insulating substrate in such a manner that the wiring patterns include at least first, second and third electrodes and the first and second electrodes are spaced from each other by a certain distance; printing a first resistor paste on the surface in such a manner that the first resistor paste has respective ends connected with the first and second electrodes, respectively, and simultaneously printing a second resistor paste on a certain area within a top plane area of the third electrode; heating and curing the printed first and second resistor pastes to form first and second resistors, respectively; and forming a fourth electrode on an area within a top plane area of the second resistor.

### BRIEF DESCRIPTION OF THE DRAWINGS

Fig. 1 is an enlarged plan view of an electrode part including a vertical resistor formed on a wiring board according to a first embodiment of this invention;
Fig. 2 is a side view of the part shown in Fig. 1 as seen in the direction indicated by an arrow II in Fig. 1;
Fig. 3 is a flow chart for schematically illustrating the steps of a manufacturing process of the wiring board according to the first embodiment of the present invention;
Figs. 4(a) to 4(i) are illustrations of the wiring board in the respective steps of the manufacturing process according to the first embodiment;
Fig. 5 is an illustration of a second embodiment of this invention wherein a vertical resistor and a plane resistor are formed;
Fig. 6 is a plan view of Fig. 5; and
Figs. 7(a) to 7(i) are illustrations of the wiring board in the respective steps of the manufacturing process according to the second embodiment.

### BEST MODE FOR CARRYING OUT THE INVENTION

The preferred embodiments of the inventive wiring board will be described below with reference to the drawings.

The inventive wiring board is characterized in that a resistor is incorporated in a substrate together with a wiring pattern.

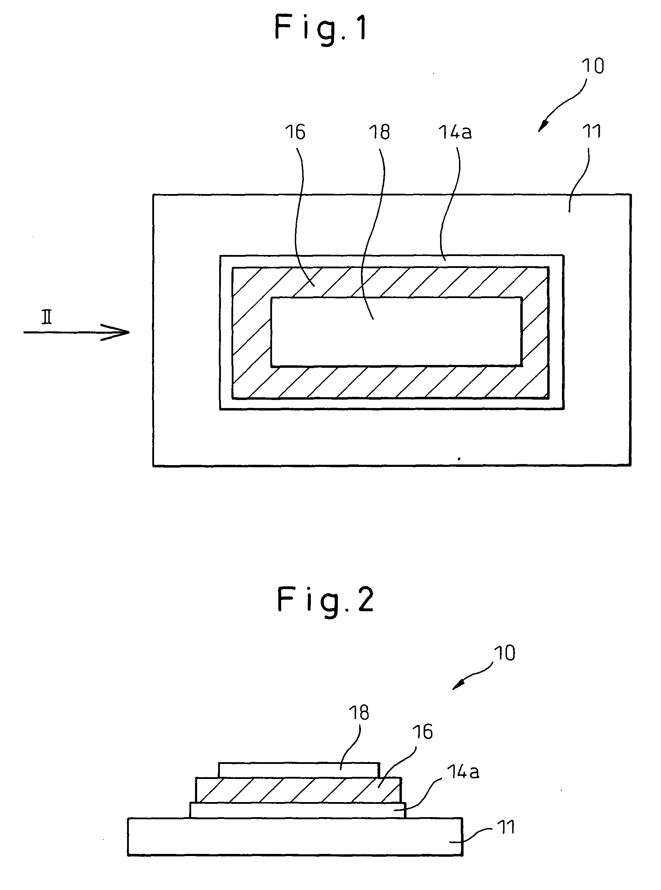

Fig. 1 is an enlarged plan view of a resistor formed on a wiring board and electrode members formed to be connected to the resistor. Fig. 2 is a side view as seen in the direction indicated by an arrow II in Fig. 1.

As shown in Figs. 1 and 2, when a resistor 16 is formed on a wiring board 10 according to this embodiment, a first electrode 14a which is part of a wiring pattern 14 formed on an insulating resinous substrate 11 is laminated with the resistor 15 and a second electrode 18.

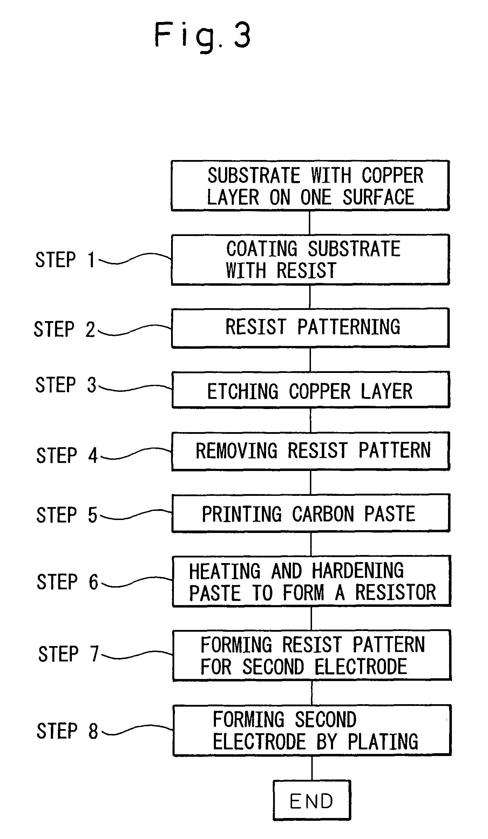

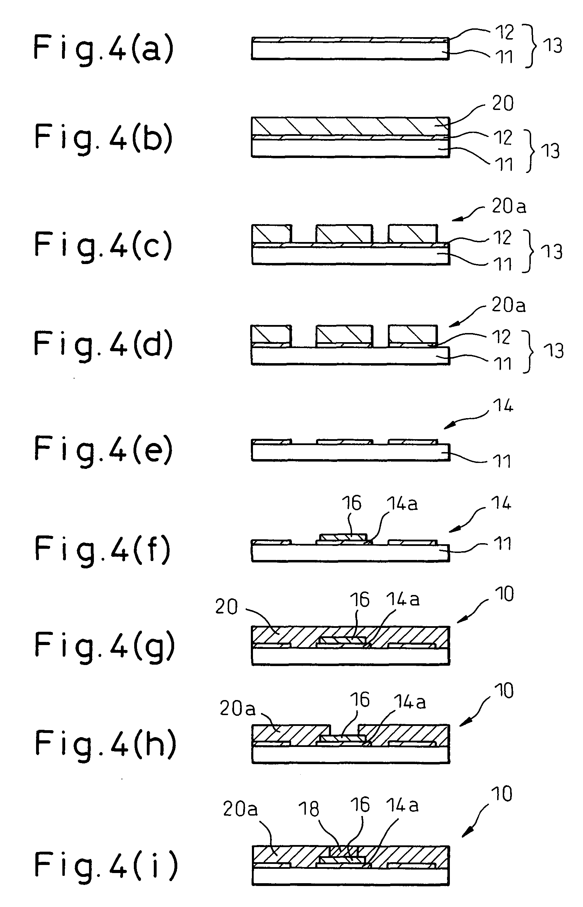

When the resistor 16 is formed on the wiring board 10, this process is carried out simultaneously with a process for forming the wiring pattern 14 on the resinous substrate 11. A method for manufacturing a wiring board of this embodiment will be described below with reference to Figs. 3 and 4.

Fig. 3 is a flow chart for schematically illustrating the steps of a manufacturing process of the wiring board according to this embodiment, and Figs. 4(a) to 4(i) are illustrations of the wiring board in the respective steps of the manufacturing process shown in Fig. 3.

First, as shown in Fig. 4(a), a one-side copper-clad board 13 (a substrate 13 with copper-layer on one surface) is prepared by adhering a copper foil 12, which is a conductive layer, to the resinous substrate 11. Then, as shown in Fig. 4(b), the one-side copper-clad board 13 is coated or covered with a photo-resist 20 (step 1). Next, the resist 20 is exposed and developed in accordance with the wiring pattern 14 to form a resist pattern 20a in which a portion to be the wiring pattern 14 is concealed as shown in Fig. 4(c) (step 2).

Then, as shown in Fig. 4(d), the part of the copper foil 12 exposed by the resist pattern 20a is removed (step 3).

Subsequently, the resist pattern 20a is removed by dissolving the same with a solvent for the resist (step 4). Fig. 4(e) illustrates a state wherein the resist pattern 20a has been removed. By the removal of the resist pattern 20a, a predetermined wiring pattern 14 is formed on the resinous substrate 11.

Then, as shown in Fig. 4(f), a resistor 16 is formed on the electrode (the first electrode) 14 which is defined as a part of the wiring pattern 14 (step 5). The resistor 16 is formable by printing a resistor paste, such as a carbon paste, while using a mask not shown having slits of a predetermined width. As shown in Fig. 1, the resistor 16 is formed by printing the resistor paste in a plane area of the first electrode 14a to be a laminate. The resistor paste is coated in a range slightly narrower than that of the first electrode 14a.

After coating the resistor paste, the resistor paste is heated and cured to form the resistor 16 (step 6).

After forming the resistor 16, the second electrode 18 is formed on the upper surface of the resistor 16. As shown in Fig. 4(g), a photosensitive resinous film 20 having the electric insulation is laminated on the surface of the wiring pattern 14 and on the resistor 16 after forming the resistor 16. As shown in Fig. 4(h), the photosensitive resinous film is exposed and developed so that a surface portion of the resistor 16 is opened to have a predetermined area (step 7). Then, a conductive layer is formed in the surface portion of the resistor 16 by the plating (step 8). Thereby, the second electrode 18 is formed on the surface of the resistor 16. Fig. 4(h) illustrates a state wherein the second electrode 18 is formed on the surface of the resistor 16.

In such a manner, the resistor 16 is formed on the surface of the first electrode 14a, and it is possible to form the second electrode 18 further on the surface of the resistor 16.

The above-mentioned connection structure of the resistor 16 is characterized in that the first electrode 14a and the second electrode 18 are provided while holding the resistor 16 between the two, as seen in the thickness direction.

Also, since the second electrode 18 is formed to be somewhat smaller than the surface of the resistor 16, there would be no damage in the resinous substrate 11 even if the trimming of the resistor 16 is carried out by the laser beam trimming when the electric resistance value of the resistor 16 thus formed is out of the tolerance of a designed resistance value, because the laser beam would be reflected by the first electrode 14a.

On the other hand, it may be possible to form a plane connection resistor 30 on the surface of the substrate on which the wiring pattern 14 is formed, and arrange the electrodes 14a at opposite end of the plane connection resistor 30 formed on the wiring board 10.

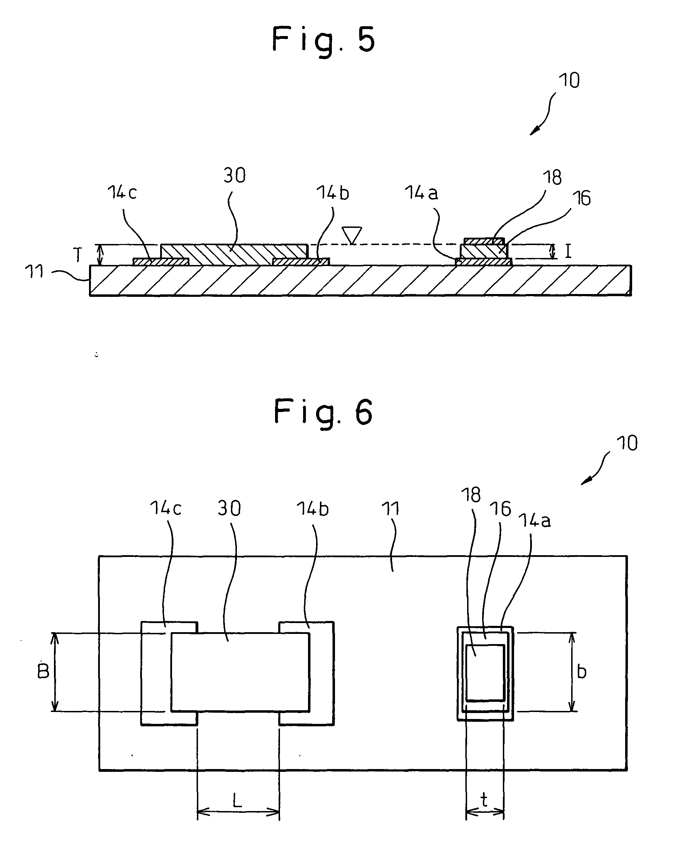

Fig. 5 illustrates a connecting structure forming the first and second electrodes on opposite surfaces, respectively, of the resistor as seen in the thickness direction, and a connecting structure wherein a pair of electrodes are provided on a surface of the resinous substrate on which the wiring pattern is formed and the resistor is formed between the electrodes. Fig. 6 is a plan view of Fig. 5.

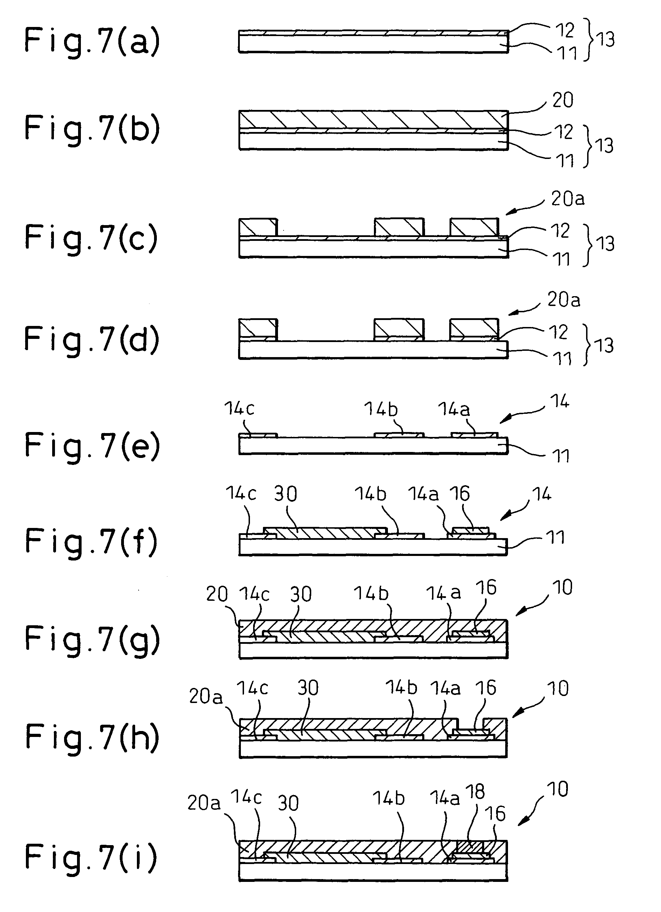

Figs. 7(a) to 7(i) are illustrations, similar to Figs. 4(a) to 4(i), but showing the respective steps of the manufacturing the wiring board of the second embodiment shown in Figs. 5 and 6. Steps shown in Figs. 7(a) to 7(e) substantially correspond to those shown in Figs. 4(a) to 4(e) as follows.

First, as shown in Fig. 7(a), a one-side copper-clad board 13 is prepared by adhering a copper foil 12 which is a conductive layer to the resinous substrate 11. Then, as shown in Fig. 7(b), the one-side copper-clad board 13 is covered with a resist 20. Next, the resist 20 is exposed and developed in accordance with the wiring patterns 14 to form resist patterns 20a in which portions to be the wiring patterns 14 are concealed as shown in Fig. 7(c).

Then, as shown in Fig. 7(d), parts of the copper foil 12 exposed from the resist patterns 20a are removed.

Subsequently, the resist pattern 20a is removed by dissolving the same with a solvent for the resist. Fig. 7(e) illustrates a state wherein the resist pattern 20a has been removed. By the removal of the resist pattern 20a, predetermined wiring patterns 14, to be electrodes 14a, 14b and 14c, are formed on the resinous substrate 11.

Then, as shown in Fig. 7(f), a resistor 16 is formed on the electrode 14a and simultaneously a resistor 30 is formed on the resinous substrate 11 between and connected to the respective electrode 14b and 14c. These resistors 16 and 30 are simultaneously formable by printing a resistor paste, such as carbon paste, while using a mask (not shown) having slits of a predetermined width. As shown in Figs. 5 and 6, the resistors 16 and 30 are formed by simultaneously printing the resistor paste, respectively, in a plane area on the first electrode 14a and in a predetermined area on the resinous substrate 11 between the electrodes 14b and 14c.

After coating the resistor pastes, the resistor pastes are heated and cured to form the resistors 16 and 30.

In the same manner as the embodiment shown in Figs. 4(a) to 4(i), after forming the resistor 16, the second electrode 18 is formed on the upper surface of the resistor 16. As shown in Fig. 7(g), a photosensitive resinous film 20 having electric insulation is laminated on the surface of the wiring pattern 14 as well as the resistors 16 and 30. As shown in Fig. 7(h), the photosensitive resinous film 20 is exposed and developed so that a surface portion of the resistor 16 opens to have a predetermined area. Then, a conductive layer is formed in the surface portion of the resistor 16 by plating. Thereby, the second electrode 18 is formed on the surface of the resistor 16. Fig. 7(i) illustrates a state wherein the second electrode 18 is formed on the surface of the resistor 16.

As mentioned above, the electrodes 14a, 14b of the plane connecting resistor 30 may be formed simultaneously with forming the wiring pattern on the resinous substrate 11. Also, the resistor 16 and the plane connecting resistor 30 may be formed simultaneously with each other by the screen printing while using a predetermined mask after the wiring pattern 14 has been formed. In this case, a height (T) position of the upper end surface of the resistor 16 coincides, of course, with a height (T) position of the upper end surface of the plane connecting resistor 30.

The electric resistance value of the structure wherein the electrodes 14a and 14b are provided in the same plane of the substrate and the plane connecting resistor 30 is formed between the electrodes 14a and 14b is determined by a width B, a thickness T and a length L of the plane connecting resistor 30 shown in Figs. 5 and 6. Accordingly, the electric resistance value of the plane connecting resistor 30 becomes larger by reducing the thickness T, reducing the width B and increasing the length L. Contrarily, the electric resistance value becomes smaller by increasing the thickness T, increasing the width B and reducing the length L.

However, since the increase in thickness T and/or width B of the plane connecting resistor 30 is restricted due to the layout of the wiring board 10, and it is impossible to obtain a desired shape of the plane connecting resistor 30 or to precisely print the resistor paste, an allowable range of the electric resistance value is limitative.

In this respect, when the electrodes 14a and 18 are disposed in the thickness direction of the resistor 16 as shown in Figs. 1, 5 and 6, an effect equivalent to substantially thickening the width of the resistor 16 (corresponding to t in Fig. 6) and shortening the length thereof (corresponding to I in Fig. 5) is obtained to effectively reduce the electric resistance value of the resistor 16.

Thereby, even if a number of kinds of resistor paste are not used, it is possible to form resistors of different electric resistance values in a wide range, for example, from several hundreds ohms to several megaohms.

Also, even in the wiring board 10 using the resinous substrate 11, it is possible to improve the yield of products without damaging the substrate body, because the laser beam is reflected by the first electrode 14a made of metal when the electric resistance value is adjusted by the laser trimming.

According to the inventive method for manufacturing the wiring board, the following effects are obtainable.

It is possible to provide a wiring board capable setting an electric resistance value of a printed resistor from a wider range even if the wiring board is formed with fewer kinds of resistor paste.

Also, it is possible to form resistors having largely different electric resistance values with a single printing of the resistor paste.

Further, since the electrodes exist on upper and lower surfaces of the resistor, it is possible to adjust the electric resistance value of the resistor by the laser trimming of the resistor without damaging the substrate which may be a resinous one.

It should be understood by those skilled in the art that the foregoing description relates to only some of the preferred embodiments of the disclosed invention, and that various changes and modifications may be made to the invention without departing from the sprit and scope thereof.

## Claims

1. A wiring board provided with a resistor, comprising:
an insulating substrate having a surface;
a wiring pattern formed on said surface, said wiring pattern including at least one first electrode occupying a first plane area on said surface;
a resistor formed on said first electrode;
a second electrode formed on said resistor; and
said resistor and said second electrode being located in a second plane area within said first plane area.

2. A wiring board as set forth in claim 1, wherein said second electrode occupies a plane area smaller than that of said resistor.

3. A wiring board provided with a resistor, comprising:
an insulating substrate having a surface;
wiring patterns formed on said surface, said wiring patterns including first and second electrodes spaced from each other by a certain distance;
a first resistor formed on said surface, said first resistor having respective ends connected with said first and second electrodes, respectively;
said wiring patterns further including a third electrode, occupying a first plane area on said surface;
a second resistor formed on said third electrode;
a fourth electrode formed on said second resistor; and said second resistor and said fourth electrode being located in a second plane area within said first plane area.

4. A wiring board as set forth in claim 3, wherein said fourth electrode occupies a plane area smaller than that of said second resistor.

5. A wiring board as set forth in claim 3, wherein said third electrode is a common electrode with one of said first and second electrodes.

6. A process for manufacturing a wiring board provided with a resistor, comprising the following steps of:
forming a wiring pattern on a surface of a insulating substrate in such a manner that said wiring pattern includes at least one, first electrode, occupying a first plane area on said surface;
printing a resistor paste on a certain area within a top plane area of said first electrode;
heating and curing the printed resistor paste to form a resistor; and
forming a second electrode on an area within a top plane area of said resistor.

7. A process for manufacturing a wiring board provided with resistors, comprising the following steps of:
forming wiring patterns on a surface of a insulating substrate in such a manner that said wiring patterns include at least first, second and third electrodes and said first and second electrodes are spaced from each other by a certain distance;
printing a first resistor paste on said surface in such a manner that said first resistor paste has respective ends connected with said first and second electrodes, respectively, and simultaneously printing a second resistor paste on a certain area within a top plane area of said third electrode;
heating and curing said printed first and second resistor pastes to form first and second resistors, respectively; and
forming a fourth electrode on an area within a top plane area of said second resistor.
